# EUROPEAN PATENT SPECIFICATION

(11) **EP 1 802 705 B1**
(45) Date of publication and mention of the grant of the patent: **21.05.2014**
(21) Application number: 05794683.2
(22) Date of filing: 30.09.2005
(51) Int. Cl.: H05K 1/03, C08L 81/06

(54) **SULFONE POLYMER COMPOSITION**
SULFONPOLYMERZUSAMMENSETZUNG
COMPOSITION DE POLYMERE SULFONE

(30) Priority: 04.10.2004 US 614973 P; 04.10.2004 US 614974 P; 04.10.2004 US 615023 P; 19.10.2004 US 619694 P; 19.10.2004 US 619695 P; 22.12.2004 EP 04106878; 22.12.2004 EP 04106876; 22.12.2004 EP 04106875; 22.12.2004 EP 04106879; 31.03.2005 EP 05102551; 12.04.2005 US 670266 P
(43) Date of publication of application: 04.07.2007
(73) Proprietor: Solvay Specialty Polymers USA, LLC., Alpharetta, GA 30005 (US)
(72) Inventor: EL-HIBRI, Mohammad Jamal, Atlanta, GA 30328 (US)
(74) Representative: Vande Gucht, Anne
(86) International application number: PCT/EP2005/054936
(87) International publication number: WO 2006/037755

(56) References cited:
- EP-A- 0 176 989
- EP-A- 0 215 580
- EP-A- 0 332 012

## Description

Numerous blends of various poly(aryl ether sulfone) have been described in US 4,804,723 (to Amoco Corporation), to the specific purpose of providing miscible compositions. Thus, example 2 of said patent discloses a miscible blend composed of 50 parts by weight of polyphenylsulfone and 50 parts by weight of polybiphenyldisulfone. Example 12 of same patent discloses a miscible blend composed of 70 parts by weight of polyphenylsulfone and 30 parts by weight of a copolymer of polybiphenyldisulfone. The problem of providing a sulfone polymer composition having a good balance between high temperature performances and resilience, especially impact resistance, is not addressed.

In contrast, the invention concerns a sulfone polymer composition having a good balance between high temperature performances and resilience, and an article comprising said composition.

High glass transition temperature sulfone polymers are appreciated because of their outstanding heat resistance, dimensional stability, good chemical resistance and mechanical integrity up to operating temperature of about 250°C.

Nevertheless, these high glass transition temperature sulfone polymers present several drawbacks, in particular a poor toughness, which make them unsuitable for application where impact resistance is required. Moreover, they are highly costly, due to the expensive monomers required for their synthesis.

The above-mentioned drawbacks and others are remarkably overcome by a sulfone polymer composition comprising :
- at least one high glass transition temperature sulfone polymer [polymer (A)], at least 50 % wt of the recurring units thereof are recurring units (R1) : 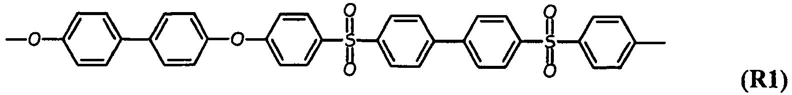
- at least one highly tough sulfone polymer [polymer (B)], at least 50 % wt of the recurring units thereof are recurring units (R3) : 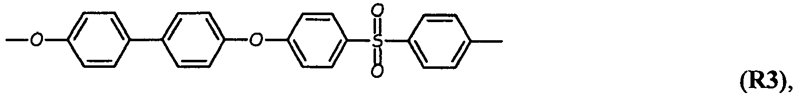 said sulfone polymer composition comprising from 30 % wt. to 70 % wt. of polymer (A), with respect to the total weight of (A) and (B),
with the exception of :
- a sulfone polymer composition comprising 50 % wt. of polymer (A), with respect to the total weight of (A) and (B), and
- a sulfone polymer composition composed of 30 % wt of a polymer 75 % mol of the recurring units thereof are recurring units (R1) and 25 % mol of the recurring units thereof are recurring units (iii) 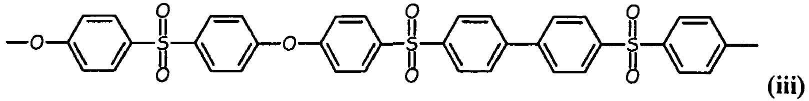
and 70 % wt of polyphenylsulfone.

The composition of the invention possesses advantageously thermal performances and toughness advantages in addition to minor cost with respect to high glass transition sulfone polymers.

For the purpose of the invention, the term "polymer" is intended to denote any material consisting essentially of recurring units, and having a molecular weight above 2000.

For the purpose of the invention, the term "high glass transition temperature sulfone polymer" is intended to denote any polymer, at least 50 % wt of recurring units thereof being recurring units (R1) :

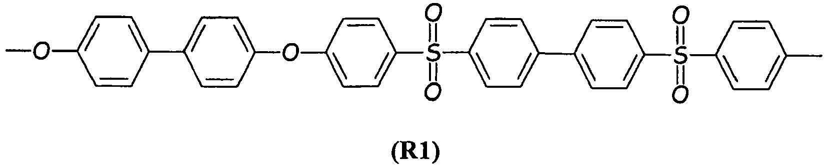

Optionally, polymer (A) further comprises recurring units (R2) : 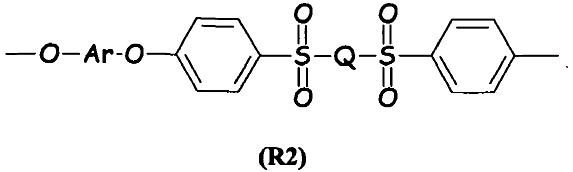 wherein :
- Q is a group chosen among the following structures : 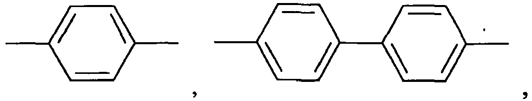 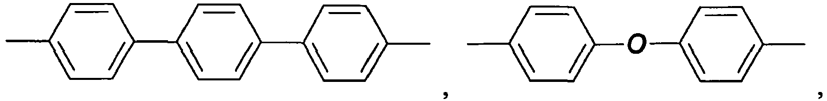 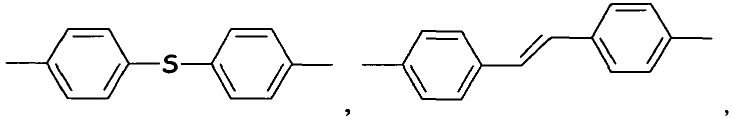 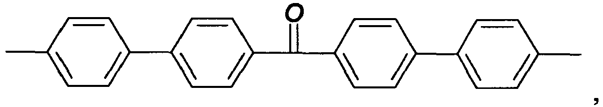 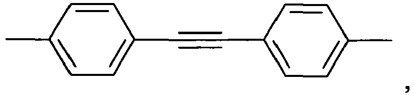 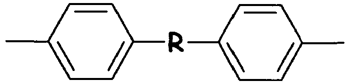 with R being: 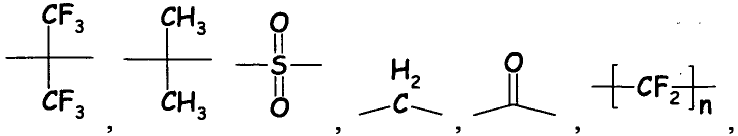 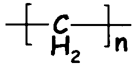 with n = integer from 1 to 6, or an aliphatic divalent group, linear or branched, of up to 6 carbon atoms;
   and mixtures thereof; and
- Ar is a group chosen among the following structures : 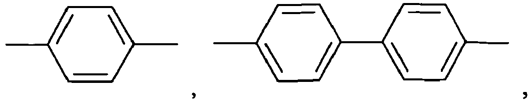 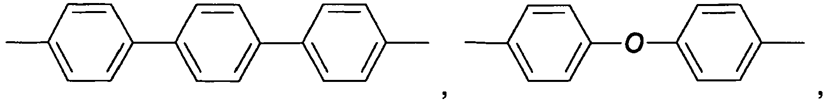 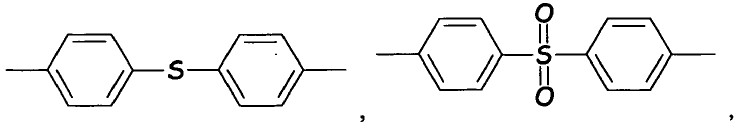 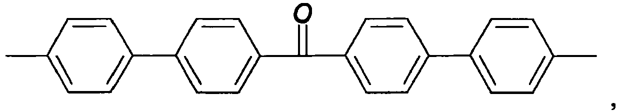 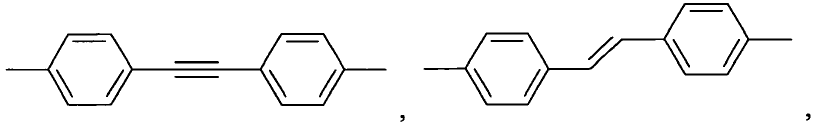 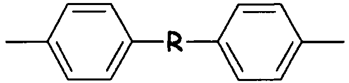 with **R** being: 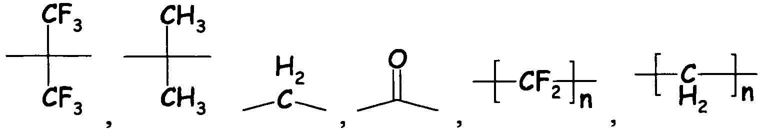 with n = integer from 1 to 6, or an aliphatic divalent group, linear or branched, of up to 6 carbon atoms;
   and mixtures thereof.

Recurring units (R2) are preferably chosen from: 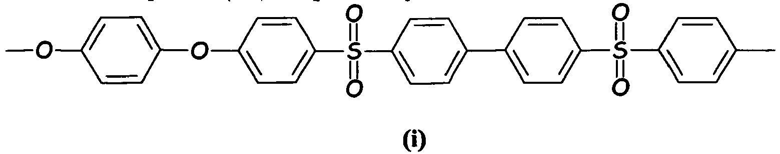 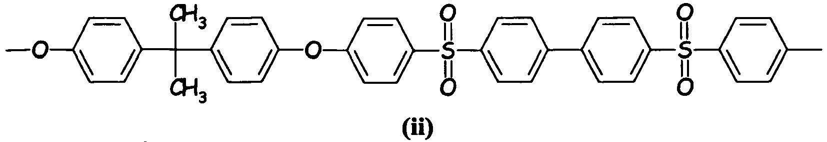 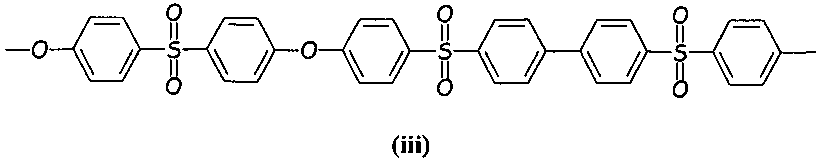 and mixtures therefrom.

Polymer (A) can be either a homopolymer or a random, alternating or block copolymer.

Preferably 70 % wt, more preferably 75 % wt, even more preferably 80 % wt of the recurring units of polymer (A) are recurring units (R1). Still more preferably, polymer (A) is a homopolymer of recurring units (R1).

Polymer (A) obtained from the polycondensation of 4,4'-bis-(4-chlorophenyl sulfonyl)biphenyl and 4,4'-dihydroxydiphenyl (polybiphenyldisulfone, hereinafter) is an example of homopolymer.

Polymer (A) has a glass transition temperature of advantageously at least 230°C, preferably at least 240°C, more preferably at least 250°C.

In a first preferred embodiment of the invention, the sulfone polymer composition comprises less than 50 % wt, preferably less than or equal to 49 % wt, more preferably less than or equal to 48 % wt, still more preferably less than or equal to 47 % wt of polymer (A), with respect to the total weight of (A) and (B).

In this embodiment, excellent results were obtained with sulfone polymer compositions comprising less than or equal to 45 % wt of polymer (A), with respect to the total weight of (A) and (B).

In this embodiment, the sulfone polymer composition comprises at least 30 % wt, most preferably at least 40 % wt of polymer (A), with respect to the total weight of (A) and (B).

In a second preferred embodiment of the invention, the sulfone polymer composition comprises more than 50 % wt of polymer (A), preferably more that or equal to 51 % wt, more preferably more that or equal to 52 % wt, still more preferably more that or equal to 53 % wt with respect to the total weight of (A) and (B).

In this embodiment, excellent results were obtained with sulfone polymer compositions comprising more than or equal to 55 % wt of polymer (A), with respect to the total weight of (A) and (B).

In this embodiment, the sulfone polymer composition comprises at most 70 % wt, most preferably at most 60 % wt of polymer (A), with respect to the total weight of (A) and (B).

For the purpose of the invention, the term "highly tough sulfone polymer" (B) is intended to denote any polymer, at least 50 % wt of recurring units thereof being recurring units (R3) :

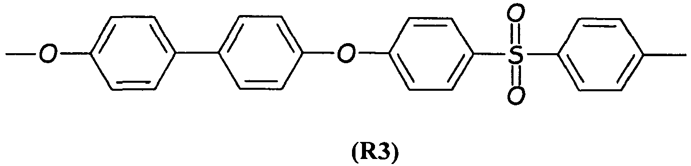

Optionally, polymer (B) further comprises recurring units (R4) : 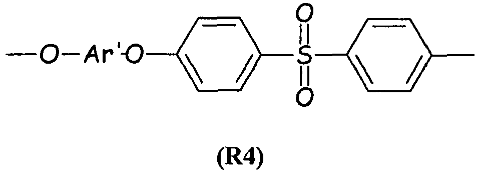
wherein Ar' is a group chosen among the following structures : 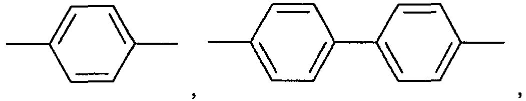 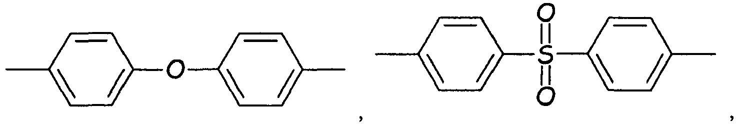 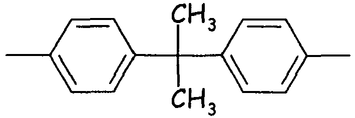 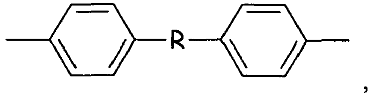 with R being an aliphatic divalent group of up to 6 carbon atoms, such as methylene, ethylene, isopropylene and the like.

Recurring units (R4) are preferably chosen from : 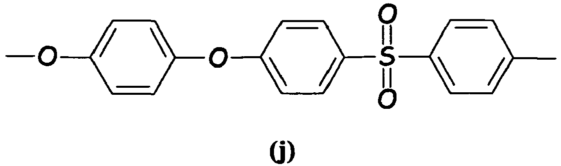 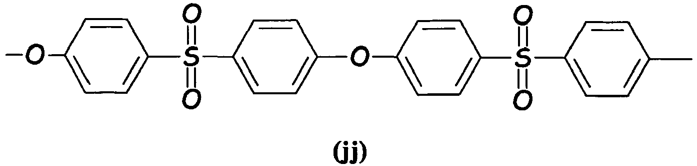 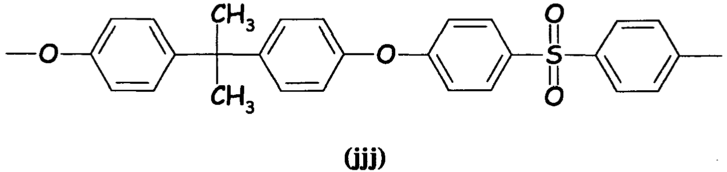 and mixtures therefrom.

Polymer (B) may notably be a homopolymer, a random, alternating or block copolymer.

Preferably at least 70 % wt, more preferably at least 75 % wt of the recurring units of polymer (B) are recurring units (R3). Still more preferably, polymer (B) is a homopolymer of recurring units (R3).

RADEL® R PPSF polyphenylsulfone from Solvay Advanced Polymers, L.L.C. is an example of homopolymer.

Polymer (B) has an impact resistance of advantageously at least 8 ft-1b/in, preferably of at least 9 ft-lb/in, more preferably of at least 10.0 ft-lb/in when measured by Notched Izod according to ASTM D256 (Test method A) at 25°C.

The polymer composition of the invention exhibits a glass transition temperature of advantageously at least 220°C, preferably at least 225°C, more preferably at least 230°C.

The polymer composition of the invention exhibits an impact resistance of advantageously at least 7 ft-lb/in, preferably of at least 8 ft-lb/in, more preferably of at least 9.0 ft-lb/in, still more preferably of at least 10.0 ft-lb/in when measured by Notched Izod according to ASTM D256 (Test method A) at 25°C.

The polymer composition of the invention may notably further comprises at least one filler. The filler is preferably chosen from glass fiber, carbon or graphite fibers, fibers formed of silicon carbide, alumina, titania, boron, flake, spherical and fibrous particulate filler reinforcements and nucleating agents such as talc, mica, titanium dioxide, potassium titanate, silica, kaolin, chalk, alumina, mineral fillers, and the like.

The polymer composition of the invention may also further comprise notably pigments, stabilizers, i.e., metal oxides such as zinc oxide, antioxidants and/or flame retardants.

Another object of the invention is an article comprising the polymer composition as above described.

Advantageously the article is an injection molded article, an extrusion molded article, a shaped article, a coated article or a casted article.

The articles according to the invention can be fabricated by processing the polymer composition as above described following standard methods.

Non limitative examples of articles are shaped articles, electronic components (such as printed circuit boards, electrical plug-in connectors, bobbins for relays and solenoids), pipes, fittings, housings, films, membranes, coatings.

Another aspect of the present invention concerns a process for manufacturing the polymer composition as above described, which comprises mixing the polymer (A) and the polymer (B).

Advantageously, the process comprises mixing by dry blending and/or melt compounding the polymer (A) and the polymer (B).

Preferably, the polymer (A) and the polymer (B) are mixed by melt compounding.

Advantageously, the polymer (A) and the polymer (B) are melt compounded in continuous or batch devices. Such devices are well-known to those skilled in the art.

Examples of suitable continuous devices to melt compound the polymer composition of the invention are notably screw extruders. Thus, the polymer (A), the polymer (B), and optionally other ingredients, are advantageously fed in powder or granular form in an extruder and the polymer composition, as above described is advantageously extruded into strands and the strands are advantageously chopped into pellets.

Optionally, fillers, lubricating agents, heat stabilizer, anti-static agents, extenders, reinforcing agents, organic and/or inorganic pigments like TiO₂, carbon black, acid scavengers, such as MgO, flame-retardants, smoke-suppressing agents may be added to the composition during the compounding step.

Preferably, the polymer (A) and the polymer (B) are melt compounded in a twin-screw extruder.

The polymer composition of the invention can be processed following standard methods for injection molding, extrusion, thermoforming, machining, and blow molding. Solution-based processing for coatings and membranes is also possible. Finished articles comprising the polymer composition as above described can undergo standard post-fabrication operations such as ultrasonic welding, adhesive bonding, and laser marking as well as heat staking, threading, and machining.

The present invention is described in greater detail below by referring to the Examples; however, the present invention is not limited to these examples.

### Raw materials :

Polybiphenyldisulfone obtained from the polycondensation of 4,4'-bis-(4-chlorophenyl sulfonyl)biphenyl and 4,4'-dihydroxydiphenyl was used. The table 1 here below summarizes main properties of the material used in preparing the composition :

**Table 1- Properties of the polybiphenyldisulfone**

| | | Polybiphenyldisulfone |
|---|---|---|
| GPC measurements | Mₙ (Dalton) | 17670 |
| | M_{w} (Dalton) | 47200 |
| | M_{W}/Mₙ | 2.67 |
| DSC measurements | T_{g} (°C) | 264.7 |
| Melt flow index^{(†)} | MFI [400°C/5 kg] (g/10 min) | 28.5 |
| Mechanical Properties | Tensile Modulus^{(□)} (Kpsi) | 312 |
| | Elongation at yield^{(□)} (%) | 8.5 |
| | Elongation at break^{(□)} (%) | 18.0 |
| | Notched Izod ^{(‡)} (ft-lb/in) | 3.1 ^{(*)} |
| | HDT [annealed] ^{(§)} (°C) | n.d. |

| | | |
|---|---|---|
| (†) Melt flow index measured according to ASTM D 1238, at a temperature of 400°C, under a load of 5 kg. (□) Tensile properties measured according to ASTM D 638. (‡) Notched Izod has been measured at 25°C according to ASTM D256 (Test method A). (§) Test parts were annealed at 250°C for 1 hour prior to HDT testing. Heat Deflection Temperature (HDT) has been measured according to ASTM D648. (*) Izod break type : Complete. | | |

RADEL® R-5800 NT polyphenylsulfone commercially available from Solvay Advanced Polymers, a sulfone polymer obtained from the polycondensation of a 4,4'-dihalodiphenylsulfone and 4,4'-dihydroxydiphenyl, has been used. Table 2 here below summarizes main properties of the material used in preparing the compositions :

**Table 2 - Properties of the polyphenylsulfone**

| | | RADEL® R-5800 NT polyphenylsulfone |
|---|---|---|
| DSC measurements | T_{g} (°C) | 219.4 |
| Melt flow index^{(†)} | MFI [400°C/5 kg] (g/10 min) | 46.4 |
| Mechanical Properties | Tensile Modulus^{(□)} (Kpsi) | 414 |
| | Elongation at yield^{(□)} (%) | 7.3 |
| | Elongation at break^{(□)} (%) | 110 |
| | Notched Izod ^{(‡)} (ft-lb/in) | 12.8^{(†)} |
| | HDT [annealed] ^{(§)}(°C) | 210 |

| | | |
|---|---|---|
| (†) Melt flow index measured according to ASTM D 1238, at a temperature of 400°C, under a load of 5 kg. (□) Tensile properties measured according to ASTM D 638. (‡) Notched Izod has been measured at 25°C according to ASTM D256 (Test method A). (§) Test parts were annealed at 200°C for 1 hour prior to HDT testing. Heat Deflection Temperature (HDT) has been measured according to ASTM D648. (†) Izod break type : Partial | | |

### Compounding procedure :

The compositions were melt compounded using a 25 mm diameter twin screw double vented Berstorff extruder having an L/D ratio of 33/1 according to the temperature profile shown in Table 1. The first vent port was open to the atmosphere; the second was connected to a vacuum pump. The extruder was fitted with a double strand die. The polymer extrudate was pelletized after passing through a water trough for cooling. The blend was extruded and pelletized without incident at the throughput rates indicated in Table 3.

**Table 3 - Compounding conditions**

| Barrel temperature (°C) | |
|---|---|
| Throat | No heat |
| Zone 1 | 315 |
| Zone 2 | 335 |
| Zone 3 | 335 |
| Zone 4 | 340 |
| Zone 5 | 335 |
| Zone 6 | 340 |
| Zone 7 | 330 |
| Die | 345 |
| | |
| Melt temperature | 390-410 °C |
| Screw Speed | 200 rpm |
| Throughput rate | 14 lb/hr |
| Vent 1 (at zone 1) | Open to atmosphere |
| Vent 2 (at zone 6) | 30 in Hg Vacuum |

### Injection molding procedure

Following compounding, the resin pellets from the various resins and composition were dried for about 16 hrs in a 149°C (300 F) desiccated hot air oven with a due point of -37.2°C (-35 F). Parts were then injection molded into 1/8" thick ASTM tensile and flexural test specimens using a Wasp Mini-Jector benchtop injection molding machine equipped with a 3/4" general purpose screw and a 20 L/D. Injection molding machine temperature settings were 395°C, 400°C and 405°C for the rear, front and nozzle sections respectively. An injection pressure of 1100 psi was used along with a mold temperature of 85°C (185 F) and a screw speed of 60 RPM.

### Mechanical Properties Determinations

A standard flexural bar 5" × ½" × ⅛" was used for ASTM D648 HDT determinations and for ASTM D256 Notched Izod measurements (Test method A). A type I ASTM tensile bar, 4.5" in gage length × ½" wide × ⅛" thick was used for ASTM D638 Tensile properties determinations.

### Example 1

A blend of the polybiphenyldisulfone and of RADEL® R-5800 NT polyphenylsulfone was prepared by melt compounding as specified here above. Details of composition and characterization of the blend are summarized in Table 4 here below.

**Table 4 - Composition and characterization of the blend**

| | | **Example 1** |
|---|---|---|
| Composition | Polybiphenyldisulfone (% wt) | 55 |
| | RADEL® R-5800 NT polyphenylsulfone (% wt) | 45 |
| DSC measurements | T_{g} (°C) | 244.3 |
| Melt flow index^{(†)} | MFI [400°C/5 kg] (g/10 min) | 42.3 |
| Mechanical Properties | Tensile Modulus^{(□)} (Kpsi) | 320 |
| | Elongation at yield^{(□)} (%) | 7.9 |
| | Elongation at break^{(□)} (%) | 67 |
| | Notched Izod^{(‡)} (ft-lb/in) | 10.0 |
| | HDT [annealed] ^{(§)} (°C) | 233.7 |
| Transparency | (comments) | Transparent |

| | | |
|---|---|---|
| (†) Melt flow index measured according to ASTM D 1238, at a temperature of 400°C, under a load of 5 kg. (‡) Notched Izod has been measured at 25°C according to ASTM D256 (Test method A). (§) Test parts were annealed at 230°C for 1 hour prior to HDT testing. Heat Deflection Temperature (HDT) has been measured according to ASTM D648. (□) Tensile properties measured according to ASTM D 638. | | |

## Claims

1. Sulfone polymer composition comprising :
- at least one high glass transition temperature sulfone polymer [polymer (A)], at least 50 % wt of the recurring units thereof are recurring units (R1) : 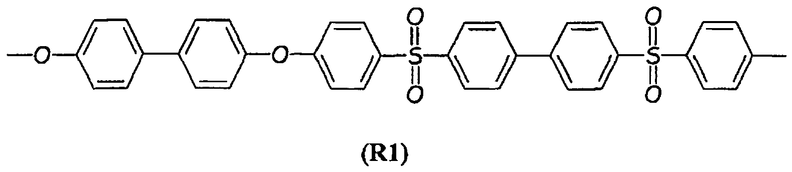
- at least one highly tough sulfone polymer [polymer (B)], at least 50 % wt of the recurring units thereof are recurring units (R3) : 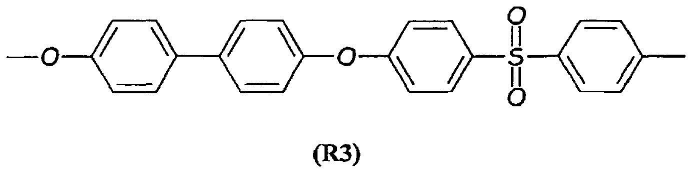 **characterized in that** it comprises from 30 % wt. to 70 % wt. of polymer (A), with respect to the total weight of (A) and (B),
with the exception of
- a sulfone polymer composition comprising 50 % wt. of polymer (A), with respect to the total weight of (A) and (B), and
- a sulfone polymer composition composed of 30 % wt of a polymer 75 % mol of the recurring units thereof are recurring units (R1) and 25 % mol of the recurring units thereof are recurring units (iii) 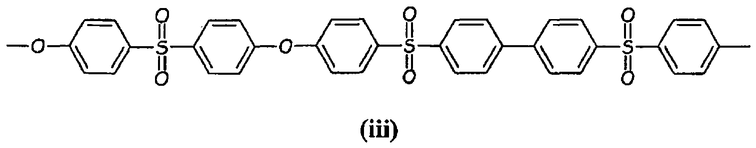 and 70 % wt of polyphenylsulfone.

2. Composition according to Claim 1, **characterized in that** it comprises at least 40 % wt. of polymer (A), with respect to the total weight of (A) and (B).

3. Composition according to Claim 1 or 2, **characterized in that** it comprises at most 60 % wt of polymer (A), with respect to the total weight of (A) and (B).

4. Composition according to Claim 1 or 2, **characterized in that** it comprises at most 48 % wt. of polymer (A), with respect to the total weight of (A) and (B).

5. Composition according to any one of the preceding Claims, **characterized in that** polymer (A) further comprises recurring units (R2) : 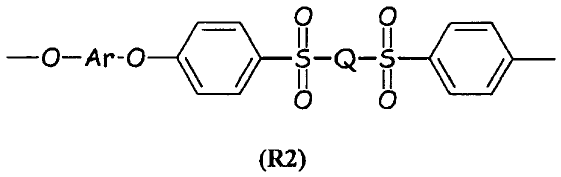 wherein:
- **Q** is a group chosen among the following structures : 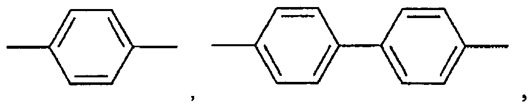 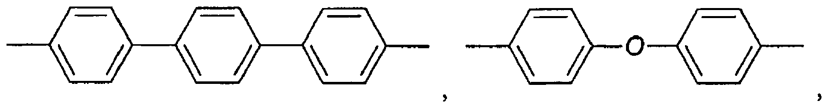 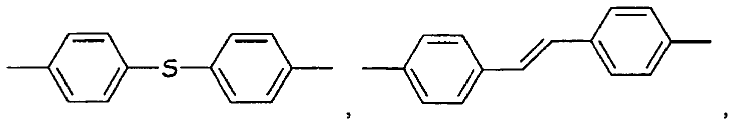 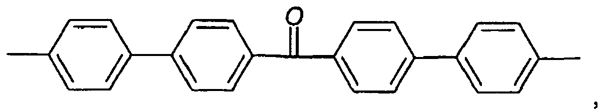 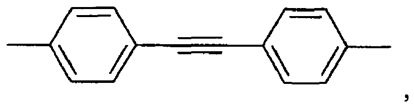 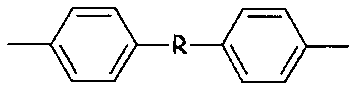 with **R** being : 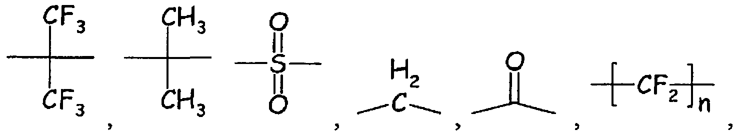 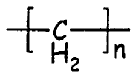 with n = integer from 1 to 6, or an aliphatic divalent group, linear or branched, of up to 6 carbon atoms;
and mixtures thereof; and
- **Ar** is a group chosen among the following structures : 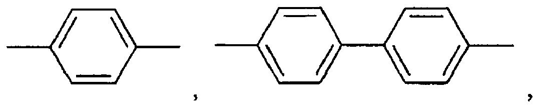 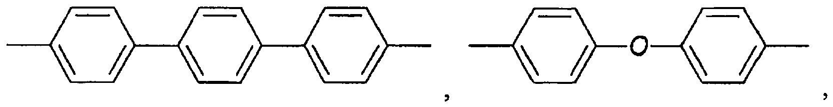 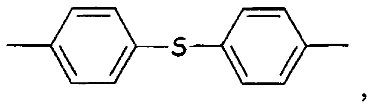 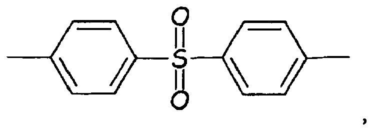 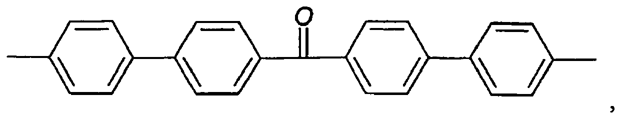 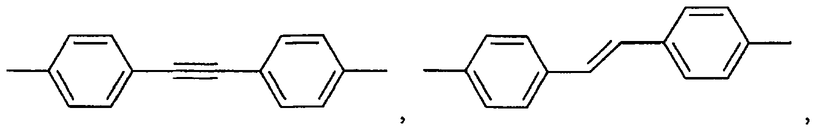 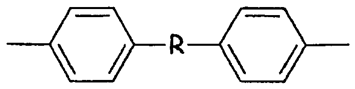 with **R** being: 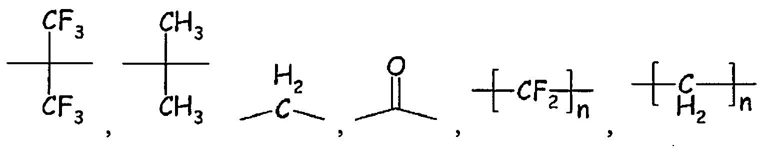 with n = integer from 1 to 6, or an aliphatic divalent group, linear or branched, of up to 6 carbon atoms;
and mixtures therof.

6. Composition according to any one of Claims 1 to 4, **characterized in that** polymer (A) is a homopolymer of recurring units (R1) and polymer (B) is a homopolymer of recurring units (R3).

7. Composition according to anyone of Claims 1 to 6, **characterized in that** it further comprises an antioxidant.

8. Process for the fabrication of an article comprising the composition according to any one of Claims 1 to 7, **characterized in that** said composition is processed using a method chosen from injection molding, extrusion molding, coating, casting and solution-based processing.

9. Article comprising the composition according to anyone of Claims 1 to 7 or fabricated by the process according to Claim 8, **characterized in that** it is chosen from electronic components, pipes, fittings, housings, films, membranes and coatings.

10. Use of from 30 % wt. to 70 % wt. of polymer (B) for increasing the impact resistance of polymer (A) up to a level of at least 38.1 kg-m/m (7 ft-lb/in) in a sulfone polymer composition comprising polymer (A) and polymer (B), wherein :
- said impact resistance is measured by Notched Izod according to ASTM D256 (Test method A) at 25°C ;
- said polymer (A) is at least one high glass transition temperature sulfone polymer, at least 50 % wt of the recurring units thereof are recurring units (R1) : 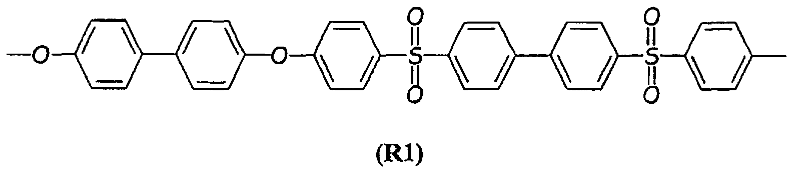
- said polymer (B) is at least one highly tough sulfone polymer, at least 50 % wt of the recurring units thereof are recurring units (R3) : 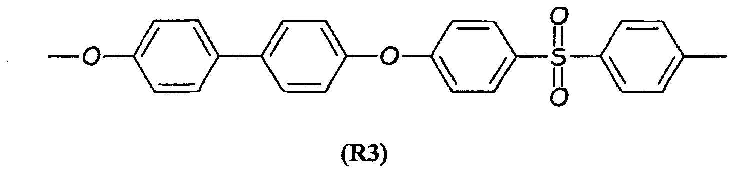 and
- the % wt. of polymer (B), as above expressed, are the % wt. of polymer (B) with respect to the total weight of (A) and (B),
with the exception of
- said use of 50 % wt. of polymer (B), and
- said use of 70 % wt of polymer (B) when all the following conditions are met :
■ polymer (B) is polyphenylsulfone
■ polymer (A) is a polymer 75 % mol of the recurring units thereof are recurring units (R1) and 25 % mol of the recurring units thereof are recurring units (iii) 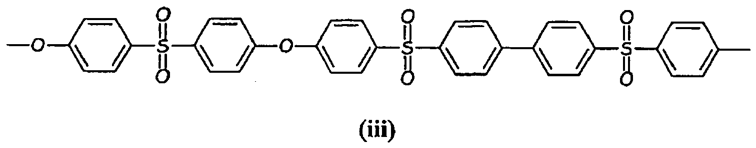 and
■ the sulfone polymer composition is composed of polymer (A) and polymer (B).

11. Use according to Claim 10, **characterized in that** the impact resistance is increased up to at least 54,4 kg-m/m (10.0 ft-lb/in).

12. Use according to Claim 10 or 11, **characterized in that** the glass transition temperature of the sulfone polymer composition is of at least 230°C, as measured by DSC on the sulfone polymer composition.

## Patentansprüche

1. Sulfonpolymerzusammensetzung, umfassend :
- mindestens ein Sulfonpolymer [Polymer (A)] mit hoher Glasübergangstemperatur, wobei es sich bei mindestens 50 Gew.- % der Wiederholungseinheiten davon um Wiederholungseinheiten (R1) handelt : 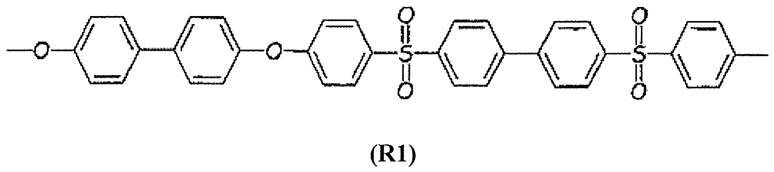
- mindestens ein hochzähes Sulfonpolymer [Polymer (B)], wobei es sich bei mindestens 50 Gew.- % der Wiederholungseinheiten davon um Wiederholungseinheiten (R3) handelt : 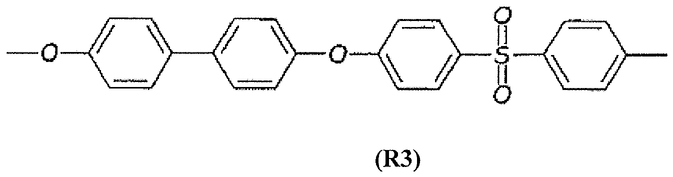 **dadurch gekennzeichnet, dass** sie 30 Gew.- % bis 70 Gew.- % Polymer (A), bezogen auf das Gesamtgewicht von (A) und (B), umfasst,
mit Ausnahme
- einer Sulfonpolymerzusammensetzung, umfassend 50 Gew.- % Polymer (A), bezogen auf das Gesamtgewicht von (A) und (B), und
- einer Sulfonpolymerzusammensetzung aus 30 Gew.- % eines Polymers, wobei es sich bei 75 Mol- % der Wiederholungseinheiten davon um Wiederholungseinheiten (R1) handelt und es sich bei 25 Mol- % der Wiederholungseinheiten davon um Wiederholungseinheiten (iii) handelt : 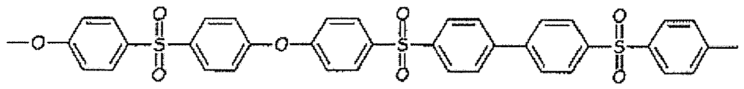 und 70 Gew.- % Polyphenylsulfon.

2. Zusammensetzung nach Anspruch 1, **dadurch gekennzeichnet, dass** sie mindestens 40 Gew.- % Polymer (A), bezogen auf das Gesamtgewicht von (A) und (B), umfasst.

3. Zusammensetzung nach Anspruch 1 oder 2, **dadurch gekennzeichnet, dass** sie höchstens 60 Gew.- % Polymer (A), bezogen auf das Gesamtgewicht von (A) und (B), umfasst.

4. Zusammensetzung nach Anspruch 1 oder 2, **dadurch gekennzeichnet, dass** sie höchstens 48 Gew.- % Polymer (A), bezogen auf das Gesamtgewicht von (A) und (B), umfasst.

5. Zusammensetzung nach einem der vorhergehenden Ansprüche, **dadurch gekennzeichnet, dass** Polymer (A) ferner Wiederholungseinheiten (R2) umfasst : 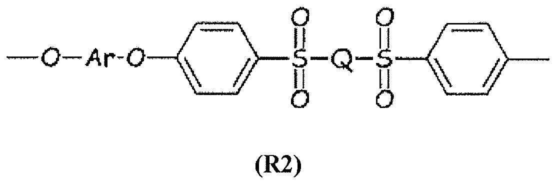 wobei:
- Q für eine unter den folgenden Strukturen : 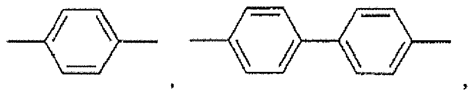 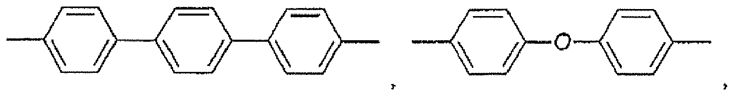 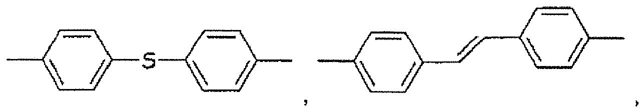 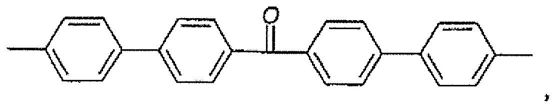 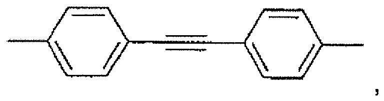 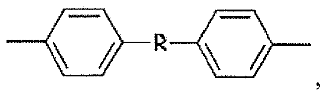 wobei R für: 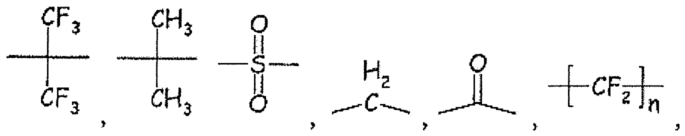 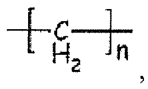 wobei n = ganze Zahl von 1 bis 6, oder eine lineare oder verzweigte aliphatische zweiwertige Gruppe mit bis zu 6 Kohlenstoffatomen steht;
und Mischungen davon ausgewählte Gruppe steht und
- **Ar** für eine unter den folgenden Strukturen : 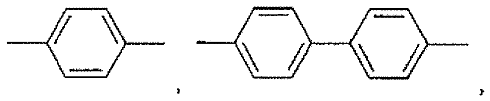 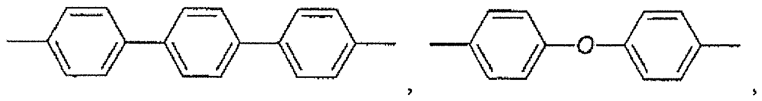 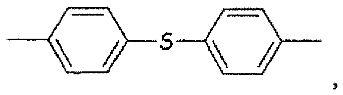 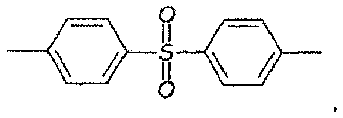 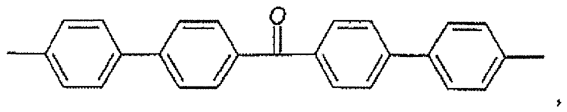 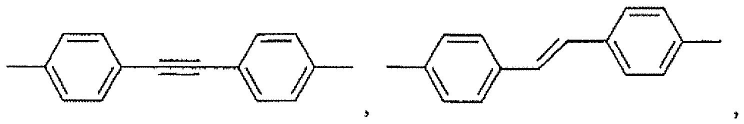 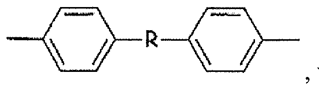 wobei R für: 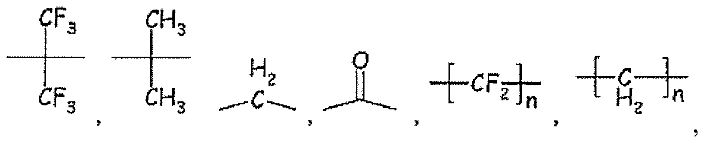 wobei n = ganze Zahl von 1 bis 6, oder eine lineare oder verzweigte aliphatische zweiwertige Gruppe mit bis zu 6 Kohlenstoffatomen steht;
und Mischungen davon ausgewählte Gruppe steht.

6. Zusammensetzung nach einem der Ansprüche 1 bis 4, **dadurch gekennzeichnet, dass** es sich bei Polymer (A) um ein Homopolymer aus Wiederholungseinheiten (R1) handelt und es sich bei Polymer (B) um ein Homopolymer aus Wiederholungseinheiten (R3) handelt.

7. Zusammensetzung nach einem der Ansprüche 1 bis 6, **dadurch gekennzeichnet, dass** sie ferner ein Antioxidans umfasst.

8. Verfahren zur Herstellung eines Gegenstands, der die Zusammensetzung nach einem der Ansprüche 1 bis 7 umfasst, **dadurch gekennzeichnet, dass** man die Zusammensetzung unter Verwendung einer aus Spritzgießen, Extrusionsformen, Beschichten, Gießen und lösungsbasierter Verarbeitung ausgewählten Methode verarbeitet.

9. Gegenstand, umfassend die Zusammensetzung nach einem der Ansprüche 1 bis 7 oder hergestellt durch das Verfahren nach Anspruch 8, **dadurch gekennzeichnet, dass** er aus Elektronikbauteilen, Rohren, Armaturen, Gehäusen, Folien, Membranen und Beschichtungen ausgewählt ist.

10. Verwendung von 30 Gew.- % bis 70 Gew.- % Polymer (B) zur Erhöhung der Schlagzähigkeit von Polymer (A) bis zu einem Niveau von mindestens 38,1 kg-m/m (7 ft-lb/in) in einer Sulfonpolymerzusammensetzung, die Polymer (A) und Polymer (B) umfasst, wobei:
- die Schlagzähigkeit durch Notched Izod gemäß ASTM D256 (Testmethode A) bei 25°C gemessen wird;
- es sich bei dem Polymer (A) um ein Sulfonpolymer mit hoher Glasübergangstemperatur handelt, wobei es sich bei mindestens 50 Gew.- % der Wiederholungseinheiten davon um Wiederholungseinheiten (R1) handelt : 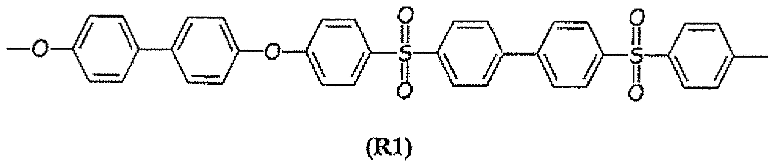
- es sich bei dem Polymer (B) um mindestens ein hochzähes Sulfonpolymer handelt, wobei es sich bei mindestens 50 Gew.- % der Wiederholungseinheiten davon um Wiederholungseinheiten (R3) handelt : 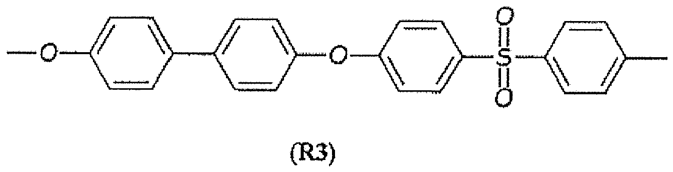 und
- es sich bei den Gew.- % von Polymer (B), wie oben ausgedrückt, um die Gew.- % von Polymer (B), bezogen auf das Gesamtgewicht von (A) und (B) handelt,
mit Ausnahme
- der Verwendung von 50 Gew.- % Polymer (B) und
- der Verwendung von 70 Gew.- % Polymer (B), wenn alle der folgenden Bedingungen erfüllt sind :
■ Polymer (B) ist Polyphenylsulfon,
■ Polymer (A) ist ein Polymer, wobei es sich bei 75 Mol- % der Wiederholungseinheiten davon um Wiederholungseinheiten (R1) handelt und es sich bei 25 Mol- % der Wiederholungseinheiten davon um Wiederholungseinheiten (iii) handelt : 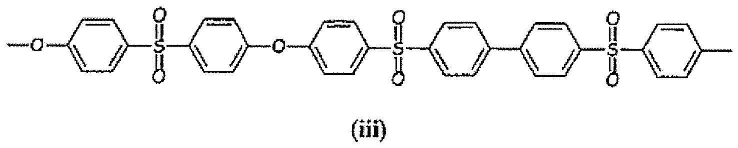 und
■ die Sulfonpolymerzusammensetzung besteht aus Polymer (A) und Polymer (B).

11. Verwendung nach Anspruch 10, **dadurch gekennzeichnet, dass** die Schlagzähigkeit bis mindestens 54,4 kg-m/m (10,0 ft-lb/in) erhöht wird.

12. Verwendung nach Anspruch 10 oder 11, **dadurch gekennzeichnet, dass** die durch DSC an der Sulfonpolymerzusammensetzung gemessene Glasübergangstemperatur der Sulfonpolymerzusammensetzung mindestens 230°C beträgt.

## Revendications

1. Composition de polymère de sulfone comprenant :
- au moins un polymère de sulfone de température de transition vitreuse élevée [polymère (A)], dont au moins 50 % en poids des motifs récurrents sont des motifs récurrents (R1) : 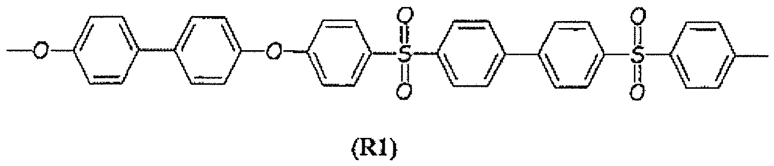
- au moins un polymère de sulfone très robuste [polymère (B)], dont au moins 50 % en poids des motifs récurrents sont des motifs récurrents (R3) : 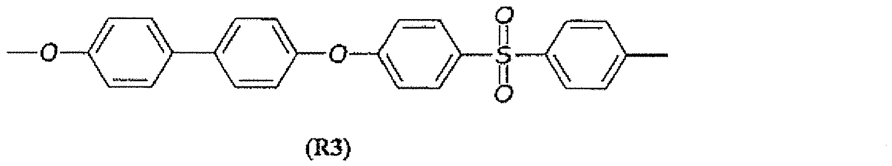 **caractérisée en ce qu'**elle comprend de 30 % en poids à 70 % en poids de polymère (A), par rapport au poids total de (A) et (B),
à l'exception de
- une composition de polymère de sulfone comprenant 50 % en poids de polymère (A), par rapport au poids total de (A) et (B), et
- une composition de polymère de sulfone composée de 30 % en poids d'un polymère dont 75 % en moles des motifs récurrents sont des motifs récurrents (R1) et dont 25 % en moles des motifs récurrents sont des motifs récurrents (iii) 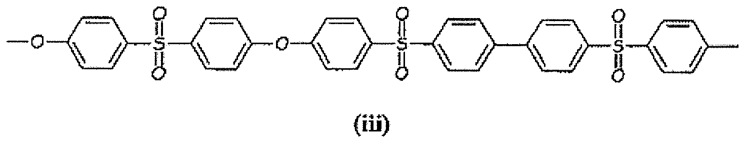 et de 70 % en poids de polyphénylsulfone.

2. Composition selon la revendication 1, **caractérisée en ce qu'**elle comprend au moins 40 % en poids de polymère (A), par rapport au poids total de (A) et (B).

3. Composition selon la revendication 1 ou 2, **caractérisée en ce qu'**elle comprend au plus 60 % en poids de polymère (A), par rapport au poids total de (A) et (B).

4. Composition selon la revendication 1 ou 2, **caractérisée en ce qu'**elle comprend au plus 48 % en poids de polymère (A), par rapport au poids total de (A) et (B).

5. Composition selon l'une quelconque des revendications précédentes, **caractérisée en ce que** le polymère (A) comprend en outre des motifs récurrents (R2) : 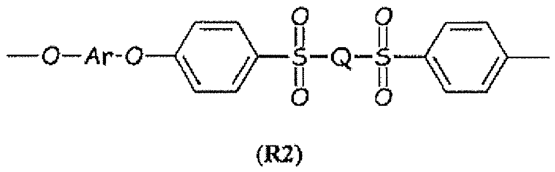 dans lesquels :
- Q représente un groupe choisi parmi les structures suivantes : 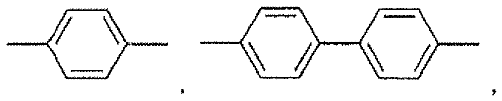 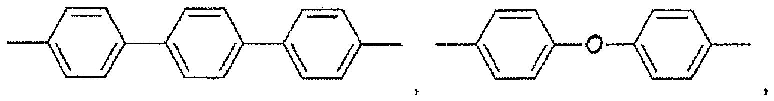 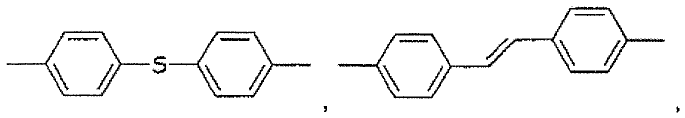 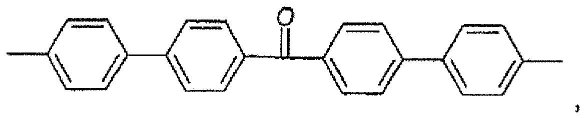 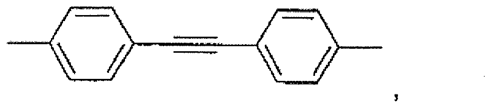 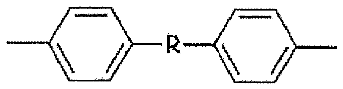 R étant : 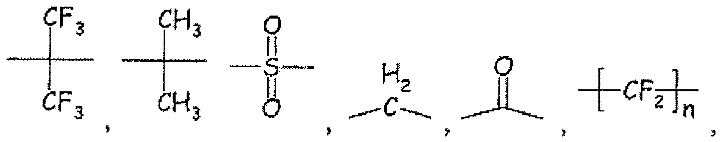 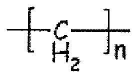 où n est un nombre entier de 1 à 6, ou un groupe divalent aliphatique, linéaire ou ramifié, comportant jusqu'à 6 atomes de carbone ;
et des mélanges de ceux-ci ; et
- Ar est un groupe choisi parmi les structures suivantes : 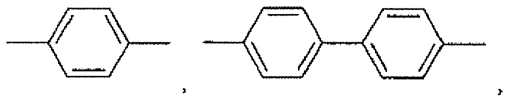 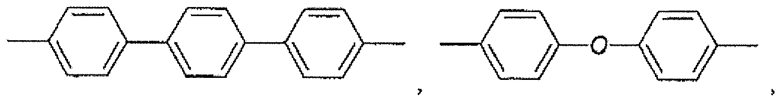 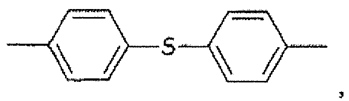 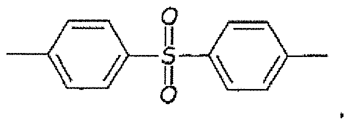 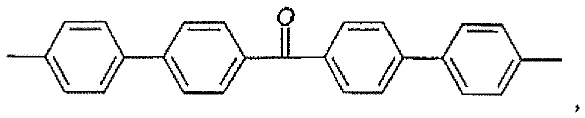 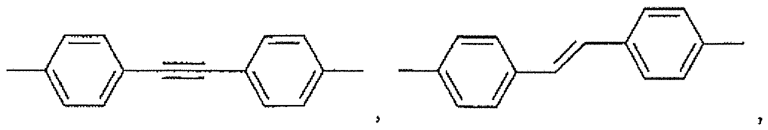 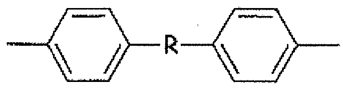 R étant : 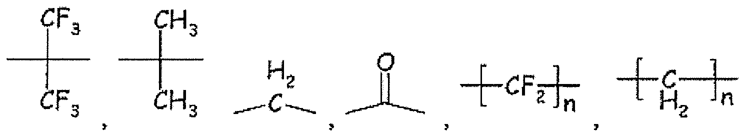 n est un nombre entier de 1 à 6, ou un groupe divalent aliphatique, linéaire ou ramifié, comportant jusqu'à 6 atomes de carbone ;
et des mélanges de ceux-ci.

6. Composition selon l'une quelconque des revendications 1 à 4, **caractérisée en ce que** le polymère (A) est un homopolymère de motifs récurrents (R1) et le polymère (B) est un homopolymère de motifs récurrents (R3).

7. Composition selon l'une quelconque des revendications 1 à 6, **caractérisée en ce qu'**elle comprend en outre un antioxydant.

8. Procédé de fabrication d'un article comprenant la composition selon l'une quelconque des revendications 1 à 7, **caractérisé en ce que** ladite composition est transformée par une méthode choisie parmi le moulage par injection, le moulage par extrusion, l'application d'un revêtement, le coulage et la transformation à base de solution.

9. Article comprenant la composition selon l'une quelconque des revendications 1 à 7 ou fabriqué par le procédé selon la revendication 8, **caractérisé en ce qu'**il est choisi parmi les composants électroniques, les tuyaux, les raccords, les boîtiers, les films, les membranes et les revêtements.

10. Utilisation de 30 % en poids à 70 % en poids de polymère (B) pour augmenter la résistance au choc du polymère (A) jusqu'à un niveau d'au moins 38,1 kg.m/m (7 ft-lb/in) dans une composition de polymère de sulfone comprenant le polymère (A) et le polymère (B), dans laquelle :
- ladite résistance au choc est mesurée par un essai Izod sur barreau entaillé selon ASTM D256 (méthode d'essai A) at 25°C ;
- ledit polymère (A) est au moins un polymère de sulfone de température de transition vitreuse élevée, dont au moins 50 % en poids des motifs récurrents sont des motifs récurrents (R1) : 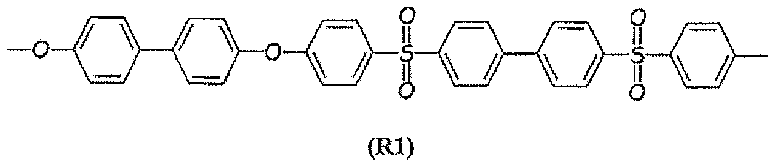
- ledit polymère (B) est au moins un polymère de sulfone très robuste, dont au moins 50 % en poids des motifs récurrents sont des motifs récurrents (R3) : 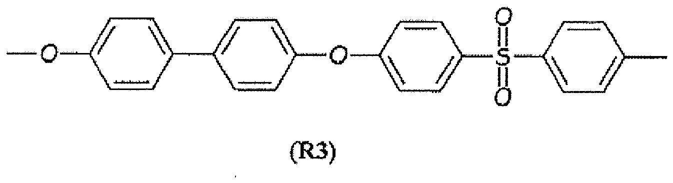 et
- les % en poids du polymère (B), tels qu'exprimés ci-dessus, sont les % en poids de polymère (B) par rapport au poids total de (A) et (B),
à l'exception de
- ladite utilisation de 50 % en poids de polymère (B), et
- ladite utilisation de 70 % en poids de polymère (B) lorsque toutes les conditions suivantes sont vérifiées :
• le polymère (B) est une polyphénylsulfone
• le polymère (A) est un polymère dont 75 % en moles des motifs récurrents sont des motifs récurrents (R1) et dont 25 % en moles des motifs récurrents sont des motifs récurrents (iii) 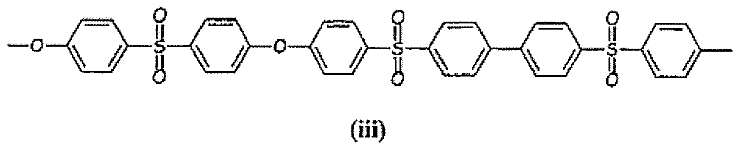 et
• la composition de polymère de sulfone est composée de polymère (A) et de polymère (B).

11. Utilisation selon la revendication 10, **caractérisée en ce que** la résistance au choc est accrue jusqu'à au moins 54,4 kg.m/m (10,0 ft-lb/in).

12. Utilisation selon la revendication 10 ou 11, **caractérisée en ce que** la température de transition vitreuse de la composition de polymère de sulfone est d'au moins 230°C, mesurée par DSC sur la composition de polymère de sulfone.
